# EUROPÄISCHE PATENTSCHRIFT

(11) **EP 0 844 325 B1**
(45) Veröffentlichungstag und Bekanntmachung des Hinweises auf die Patenterteilung: **23.04.2003**
(21) Anmeldenummer: 97119736.3
(22) Anmeldetag: 11.11.1997
(51) Int. Cl.: D06F 39/00, H01H 36/00

(54) **Betätigungs-und Anzeigevorrichtung**
Actuating and displaying device
Dispositif d'actionnement et d'affichage

(30) Priorität: 22.11.1996 DE 19648500; 22.11.1996 DE 19648499
(43) Veröffentlichungstag der Anmeldung: 27.05.1998
(73) Patentinhaber: BSH Bosch und Siemens Hausgeräte GmbH, 81669 München (DE)
(72) Erfinder: Hegewald, Ronald, 93164 Laaber (DE); Liebl, Andreas, Dipl.-Ing., 93128 Regenstauf (DE)

(56) Entgegenhaltungen:
- EP-A- 0 600 780
- EP-A- 0 867 792
- WO-A-94/17426
- DE-A- 4 432 399
- DE-U- 29 605 163
- US-A- 5 279 134
- PATENT ABSTRACTS OF JAPAN vol. 006, no. 095 (E-110), 3. Juni 1982 & JP 57 027081 A (COPAL CO LTD), 13. Februar 1982

## Beschreibung

Die Erfindung bezieht sich auf eine Betätigungs- und Anzeigevorrichtung gemäß Patentanspruch 1; eine derartige Anzeigevorrichtung ist insbesondere für den Programmwahlschalter einer Waschmaschine vorgesehen.

Bei bekannten Betätigungs- und Anzeigevorrichtungen ist rückseitig zu einer Frontblende ein mechanischer Drehwahlschalter, insbesondere als Bestandteil einer z.B. auf einer Leiterplatte angeordneten Steuerung, über eine Drehwelle mit einem vor der Frontblende liegenden Betätigungsknopf verbunden. Symbole bzw. Piktogramme der Anzeigen bzw. Benennungen der durch Drehen des Betätigungsknopfes einstellbaren verschiedenen Schalterstellungen eines Grundprogramms sind auf der Frontblende fest aufgetragen.

Durch die DE 44 32 399 A1 und in ähnlicher Weise durch die DE 693 07 480 T2 ist ein Schalter zum Steuern des elektrischen Ein- oder Ausschaltens eines Elements, insbesondere eines Heizelementes, durch eine keine Bohrung aufweisende bandförmige Tafel oder Platte aus Glas eines Haushalts Kochgerätes bekannt, wobei ein den Schalter bewirkendes Relais hinter der Tafel oder Platte aus Glas mittels eines Permanentmagneten aktiviert ist, der durch einen Schaltknopf vor der Tafel oder Platte aus Glas betätigbar ist; der zur Bedienung des Schalters vorgesehene äußere Schaltknopf ist auf einen geräteseitigen Zapfen eines Schalters aufsetzbar bzw. abnehmbar und einerseits bei Nichtgebrauch in einem Aufbewahrungsfach abgelegt und kann bei Gebrauch zur Bedienung mehrer Schalter eines Gerätes verwendet werden.

Gemäß Aufgabe vorliegender Erfindung soll eine Universal-Betätigungs- und Anzeigevorrichtung geschaffen werden, die mit einem einzigen Betätigungsknopf, insbesondere einem Dreh-Betätigungsknopf, und einer einzigen Anzeige die Einstellung und Anzeige verschiedener Grundprogramme erlaubt, wobei die Anzeige bedienungsfreundlich im gleichen Blickfeld wie der Betätigungsknopf liegen und eine Betätigung durch unberechtigte Personen, insbesondere im Sinne einer Kindersicherung, verhinderbar sein soll.

Die Lösung der vorgenannten Aufgabe gelingt erfindungsgemäß durch die Lehre des Patentanspruchs 1; vorteilhafte Ausgestaltungen der Erfindung sind jeweils Gegenstand der Unteransprüche.

"Magnetische Schalter" in Form von sogenannten MR (Magneto Resistance)- bzw. GMR (Giant Magneto Resistance)-Schaltern nutzen den sogenannten magnetoresistiven Effekt aus, der darin besteht, daß der elektrische Widerstand einer dünnen ferromagnetischen Schicht (Permalloy) vom Winkel zwischen der Richtung des in der Schicht fließenden Stromes und der Magnetisierung abhängt, die durch die Einwirkung eines äußeren, entsprechend verstellbaren Magneten bzw. dessen Magnetfeldes veränderbar ist.

Vorrichtungen, mit denen u.a. unterschiedliche Winkelpositionen durch Drehung eines Magneten zur Widerstandsänderung in einem magnetoresistiven Sensor dektektierbar sind, werden z.B. in der WO 94/17426 bzw. in der darin eingangs zitierten Philips-Druckschrift "Technische Information TI 901228" beschrieben.

Multifunktionsanzeigen mit ansteuerbaren Flüssigkristall-Anzeigefeldern sind z.B. durch "Components 30", 1992, Heft 6, Seiten 228-231 bekannt.

Weiterhin ist es durch die US 4 983 812 bekannt, zur Ein-Aus-Schaltung von Heizplatten in einer Keramik-Platte eines Elektro-Kochers durch äußeres Zu- bzw. Wegführen eines einen Dauermagneten enthaltenen Betätigungsgliedes einen magnetfeldempfindlichen Reed-Schalter hinter der Keramik-Platte zu aktivieren.

Die erfindungsgemäße Betätigungs- und Anzeigevorrichtung erlaubt trotz Anwendung einer vorteilhaften Universal-Bauausführung die Anpassung an verschiedene Einstell-Grundprogramme mit jeweils typspezifischen Benennungen der Schalterstellungen mit einer jeweiligen Darstellung entsprechend den unterschiedlichen Anzeigen mit lediglich entsprechend spezifischen Ansteuerungen des einen, als Schutz-Trennwand keinen Durchbruch aufweisenden, Flüssigkristall-Anzeigefeldes; der nur einer berechtigten Bedienperson zugeordnete Schalter ist nur von dieser in berührungslose Wirkverbindung zum zweiten Teil des GMR-Schalters bringbar, wobei eine gewisse Verkantung hinsichtlich der gegenseitigen Achsrichtung hinnehmbar ist.

Zur Groborientierung der wirksamsten Stellung des gehäuseäußeren Schalter kann z.B. auf der Vorderseite der Schutz-Trennwand eine optische Markierung oder eine mechanische Positionierhilfe, z.B. in Form eines Dreh-Steck-Stiftes oder eines Führungs-Trichters, vorgesehen sein.

Die Erfindung sowie weitere vorteilhafte Ausgestaltungen der Erfindung gemäß Merkmalen der Unteransprüche werden im folgenden anhand schematisch dargestellter Ausführungsbeispiele in der Zeichnung näher erläutert; darin zeigen:
- FIG 1: die Seitenansicht einer Bedieneinheit eines Programmwahlschalters für eine Waschmaschine mit einem an der Vorderseite einer durchsichtigen Frontblende angeordnetem Dreh-Betätigungsknopf eines magnetoresistiven Schalters und einer auf der Rückseite der Frontblende angeordneten Steuereinheit mit einem magnetoresistiven Magnetfeld-Sensor sowie mit zwischen beiden angeordnetem Flüssigkristall-Anzeigefeld;
- FIG 2: die Seitenansicht einer Bedieneinheit eines Pogrammwahlschalters, z.B. für eine Waschmaschine, mit einem an der Vorderseite einer durchsichtigen Frontblende angeordneten Dreh-Betätigungsknopf eines magnetoresistiven Schalters und einer auf der Rückseite der Frontblende angeordneten Steuereinheit mit einem magnetoresistiven Magnetfeld-Sensor sowie mit hinter der Frontblende angeordnetem Flüssigkristall-Anzeigefeld;
- FIG 3: die Vorderseite der Bedieneinheit mit einem von einem ersten Grundprogramm angesteuerten FlüssigkristallAnzeigefeld;
- FIG 4: das Flüssigkristall-Anzeigefeld gemäß FIG 3 bei Ansteuerung durch ein zweites Grundprogramm;
- FIG 5: das Flüssigkristall-Anzeigefeld gemäß FIG 3 bzw. 4 mit der Anzeige eines Funktionsablaufes.

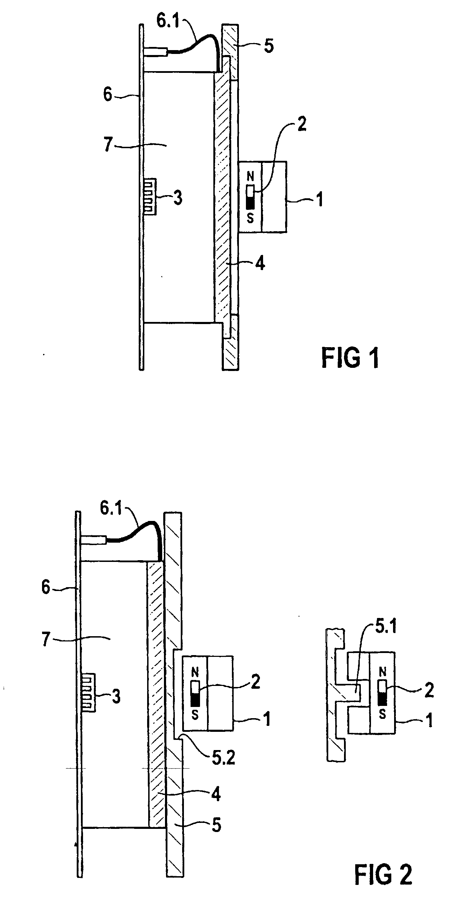

FIG 1 zeigt in Seitenansicht eine erfindungsgemäße Betätigungs- und Anzeigevorrichtung in Form eines Programmwahlschalters für eine Waschmaschine. An der Vorderseite einer Frontblende 5 mit durchsichtigem Mittelteil ist ein Dreh-Betätigungsknopf 1 vorgesehen, der als ein Teil eines GMR-Schalters einen feldorientierten Magneten 2 aufweist und unter Nutzung des sogenannten magnetoresistiven (GMR)-Effektes berührungslos mit einem Magnetfeld-Sensor 3 auf einer Leiterplatte 6 einer Steuereinheit 3;6 derart zusammenarbeitet, daß bei Drehen des Dreh-Betätigungsknopfes 1 und damit Verändern der Feldorientierung des Magneten 2 unterschiedliche Stellimpulse auf den Magnetfeld-Sensor 3 übertragen werden.

Zur Anzeige der Benennungen der Schalt- bzw. Betätigungsstellungen des Dreh-Betätigungsknopfes 1 ist als Hintergrund zu diesem und in gleichem Blickwinkel mit diesem zwischen dem rückseitigen Magnetfeld-Sensor 3 bzw. der Leiterplatte 6 einerseits und dem vorderseitigen Dreh-Betätigungsknopf 1 bzw. dem Magneten 2 andererseits ein einteiliges, eine geschlossene Oberfläche bildendes Flüssigkristall-Anzeigefeld 4 vorgesehen, dessen einzelne Segmente über eine Steuerleitung 6.1 von der Steuereinheit bzw. der Leiterplatte 6 derart polarisiert werden können, daß Schaltstellungssymbole frontseitig durch das diffuse Licht eines hinter dem Flüssigkristall-Anzeigefeld 4 angeordneten Lichtkastens 7 in Leuchtschrift im Flüssigkristall-Anzeigefeld 4 darstellbar sind.

FIG 2 zeigt die Seitenansicht einer zu der Ausführung gemäß FIG 1 ähnlichen Bedieneinheit eines Programmwahlschalters für eine Waschmaschine. An der Vorderseite einer durchsichtigen Frontblende 5 sind Positionierhilfen für den Dreh-Betätigungsknopf 1 in Form eines Dreh-Steck-Stiftes 5.1 in Richtung der fiktiven Drehachse bzw. ein entsprechender Führungstrichter 5.2 vorgesehen.

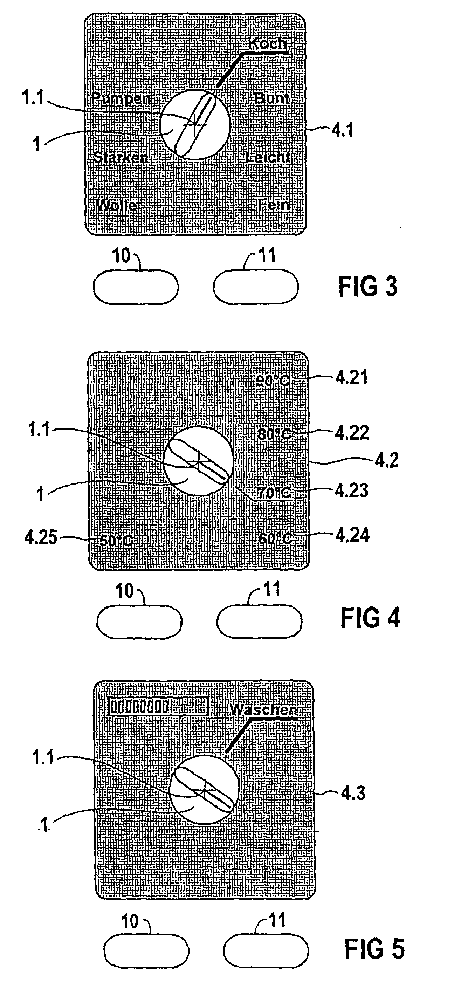

FIG 3-5 zeigen anhand dreier Beispiele die vorteilhafte Multifunktionsausnutzung des gleichen Flüssigkristall-Anzeigefeld 4 und des gleichen Dreh-Betätigungsknopf 1. Zur Einstellung der jeweiligen Funktion ist nach einer Ausgestaltung der Erfindung eine "Enter"-Taste 10 vorgesehen, durch deren unterschiedliches gezieltes mehrfaches Betätigen sukzessiv die verschiedenen Funktionen einstellbar und durch Drücken einer "Start"-Taste 11 in Gang setzbar sind.

FIG 3 zeigt ein erstes Grundprogramm 4.1 zur Einstellung verschiedener Waschprogramme, FIG 2 zeigt ein zweites Grundprogramm 4.2 zur Einstellung verschiedener, hier beispielhaft einzeln bezeichneter, Waschtemperaturen 4.21-4.25 und FIG 5 zeigt den Funktionsablauf 4.3 eines Waschvorganges; zweckmäßigerweise sind die angesteuerten jeweiligen Benennungen bzw. Anzeigen der Schaltstellungen um die fiktive Drehachse 1.1 zwischen dem Dreh-Betätigungsknopf 1 und dem rückseitig auf der Leiterplatte 6 angeordneten Magnetfeldsensor 8 angeordnet.

Nach einer besonderen Ausgestaltung der Erfindung ist ein loser, zur Einstellung in Eingriffsnähe zu dem Magntfeldsensor 3 zubringbarer und anschließend von diesem entfernbarer Dreh-Betätigungsknopf 1 vorgesehen, derart daß ein unzulässiger bzw. unbeobachteter Eingriff in das Programm dann ohne den Betätigungsknopf 1 nicht möglich ist; dabei ist aufgrund der geschlossenen Oberfläche des Flüssigkristall-Anzeigefeldes 4 und somit des fehlenden Durchbruchs für eine Drehwelle auch gewährleistet, daß ein unzulässiger bzw. ungewollter Zugriff zur Rückseite der Betätigungs- und Anzeigevorrichtung verhindert ist. Als Zuführ- bzw. Einstellhilfe für den im Falle der Bedienung wieder zubringbaren Dreh-Betätiungsknopf 1 kann die konzentrische Darstellung der Anzeigen 4.21-4.25 auf dem Flüssigkristall-Anzeigefeld 4 oder eine gesonderte Führungsmarkierung dienen, die z.B. im Punkt der fiktiven Drehachse 1.1 als Leuchtanzeige angedeutet wird sobald der Dreh-Betätigungsknopf 1 entfernt ist.

## Patentansprüche

1. Betätigungs- und Anzeigevorrichtung, insbesondere Programmwahlschalter für eine Waschmaschine,
- mit einer berührungslosen Betätigungsübertragung zwischen einem vorderseitigen Schalter, insbesondere einem Dreh-Betätigungsknopf (1), und einer rückseitigen Steuereinheit (3;6) unter Nutzung des sogenannten magnetoresistiven (GMR)-Effektes; **gekennzeichnet durch**
- ein als Hintergrundanzeige zu dem Betätigungsknopf (1) bzw. als Schutz-Trennwand zwischen diesem und der Steuereinheit (3;6) angeordnetes Flüssigkristall-Anzeigefeld (4).

2. Betätigungs- und Anzeigevorrichtung nach dem vorhergehenden Anspruch
- mit einem Schalter, insbesondere mit einem Dreh-Betätigungsknopf (1), mit einem durch dessen Verstellen in seiner Feldrichtung veränderbaren Magneten (2);
- mit einem zu dem Magneten (2) berührungslos beabstandeten, unter Nutzung des sogenannten magnetoresistiven (GMR)-Effektes zugeordneten Magnetfeld-Sensor (3);
- mit einem in einer Ebene zwischen dem Schalter, insbesondere dem Betätigungsknopf (1) bzw. dem Magneten (2) einerseits und dem Magnetfeld-Sensor (3) andererseits angeordneten Flüssigkristall-Anzeigefeld (4).

3. Betätigungs- und Anzeigevorrichtung nach dem vorhergehenden Anspruch
- mit einer fiktiven Drehachse (1.1) zwischen dem Dreh-Betätigungsknopf (1) einerseits und dem Magnetfeld-Sensor (3) andererseits;
- mit um die fiktive Drehachse (1.1) verteilten, insbesondere konzentrisch angeordneten, Betätigungsknopf-Anzeigen (z.B. 4.21-4.25).

4. Betätigungs- und Anzeigevorrichtung nach zumindest einem der vorhergehenden Ansprüche
- mit einem im Sinne einer Multifunktionsanzeige mit wechselnden Funktions-Anzeigen (4.1 bzw.4.2) und/oder Funktionsablauf-Anzeigen (4.3) ansteuerbaren Flüssigkristall-Anzeigefeld (4).

5. Betätigungs- und Anzeigevorrichtung nach dem vorhergehen den Anspruch
- mit durch eine Betätigungsvorrichtung, insbesondere durch unterschiedlich mehrfaches Betätigen zumindest einer Taste (8;9), einstellbaren unterschiedlichen Funktions-Anzeigen (4.1 bzw.4.2) bzw.Funktionsablauf-Anzeigen (4.3).

6. Betätigungs- und Anzeigevorrichtung nach zumindest einem der vorhergehenden Ansprüche
- mit einer vor dem Flüssigkristall-Anzeigefeld (4) angeordneten durchsichtigen Frontblende(5).

7. Betätigungs- und Anzeigevorrichtung nach zumindest einem der vorhergehenden Ansprüche
- mit vorderseitig der Frontblende (5) bzw. dem Flüssigkristall-Anzeigefeld (4) angeordnetem einstellbaren Betätigungsknopf (1);
- mit rückseitig der Frontblende (5) bzw. des Flüssigkristall-Anzeigefeldes (4), vorzugsweise als in Verbindung mit einer Leiterplatte, angeordnetem Magnetfeld-Sensor.

8. Betätigungs- und Anzeigevorrichtung nach zumindest einem der vorhergehenden Ansprüche
- mit einem losen in Eingriffsnähe zu dem Magnetfeld-Sensor (3) zubringbaren bzw. von diesem entfernbaren Betätigungsknopf (1).

9. Betätigungs- und Anzeigevorrichtung nach dem vorhergehenden Anspruch
- mit einer Ausricht- bzw. Einstellhilfe für den zubringbaren Betätigungsknopf (1) auf dem Flüssigkristall-Anzeigefeld (4) bzw. auf der Frontblende (5).

10. Betätigungs- und Anzeigevorrichtung nach zumindest einem der vorhergehenden Ansprüche
- mit einer Positionierhilfe (5.1;5.2) für den Schalter an der Vorderseite der Frontblende (5).

11. Betätigungs- und Anzeigevorrichtung nach dem vorhergehenden Anspruch 9
- mit einem Dreh-Steck-Stift (5.1) als Positionierhilfe.

12. Betätigungs- und Anzeigevorrichtung nach dem vorhergehenden Anspruch 9
- mit einem Führungstrichter (5.2) als Positionierhilfe.

## Claims

1. Actuating and indicating device, particularly a program selector switch for a washing machine,
- with a contactless actuating transmission between a switch at the front side, particularly a rotary actuating knob (1), and a control unit (3; 6) at the rear side with utilisation of the so-termed magneto-resistive (GMR) effect;
**characterised by**
- a liquid crystal display field (4) arranged as background indication to the actuating knob (1) and as protective separating wall between this and the control unit (3; 6).

2. Actuating and indicating device according to the preceding claim,
- with a switch, particularly with a rotary actuating knob (1), with a magnet (2) variable in the field direction thereof by adjustment of the knob;
- with a magnetic field sensor (3) associated with the magnet (2) at a contactless spacing with utilisation of the so-termed magneto-resistive (GMR) effect; and
- with a liquid crystal display field (4) arranged in a plane between the switch, particularly the actuating knob (1) or the magnet (2), on the one hand and the magnetic field sensor (3) on the other hand.

3. Actuating and indicating device according to the preceding claim,
- with a notional rotational axis (1.1) between the rotary actuating knob (1) on the one hand and the magnetic field sensor (3) on the other hand; and
- with actuating knob indications (for example, 4.21 - 4.25) arranged in distribution, particularly concentrically, around the notional rotational axis (1.1).

4. Actuating and indicating device according to at least one of the preceding claims,
- with a liquid crystal display field (4) controllable in the sense of a multi-function display with alternate function indications (4.1 or 4.2) and/or functional sequence indications (4.3).

5. Actuating and indicating device according to the preceding claim,
- with different function indications (4.1 or 4.2) or functional sequence indications (4.3) settable by an actuating device, particularly by different multiple actuation of at least one button (8; 9).

6. Actuating and indicating device according to at least one of the preceding claims,
- with a transparent front panel (5) arranged in front of the liquid crystal display field (4).

7. Actuating and indicating device according to at least one of the preceding claims,
- with a settable actuating knob (1) arranged at the front side of the front panel (5) or the liquid crystal display field (4); and
- with a magnetic field sensor arranged at the rear side of the front panel (5) or the liquid crystal display field (4), preferably in connection with a circuitboard.

8. Actuating and indicating device according to at least one of the preceding claims,
- with an actuating knob (1) able to be detachably brought into engagement proximity with the magnetic field sensor (3) and to be removable therefrom.

9. Actuating and indicating device according to the preceding claim,
- with an aligning or setting aid for the actuating knob (1), which is able to be brought up, on the liquid crystal display field (4) or on the front panel (5).

10. Actuating and indicating device according to at least one of the preceding claims,
- with a positioning aid (5.1; 5.2) for the switches at the front side of the front panel (5).

11. Actuating and indicating device according to the preceding claim 9,
- with a rotary plug pin (5.1) as positioning aid.

12. Actuating and indicating device according to the preceding claim 9,
- with a guide funnel (5.2) as positioning aid.

## Revendications

1. Dispositif d'actionnement et d'affichage, en particulier commutateur sélecteur de programmes pour un lave-linge,
- avec un dispositif de transmission de commande sans contact entre un commutateur du côté avant, en particulier un bouton de commande tournant (1), et une unité de commande du côté arrière (3 ; 6) avec utilisation du dit effet magnétorésistif (GMR) ; **caractérisé par**
- un champ d'affichage à cristaux liquides (4) disposé comme affichage de fond pour le bouton de commande (1) resp. comme paroi protectrice de séparation entre celui-ci et l'unité de commande (3 ; 6).

2. Dispositif d'actionnement et d'affichage selon la revendication précédente
- avec un commutateur, en particulier avec un bouton de commande tournant (1), avec un aimant (2) modifiable dans sa direction de champ par le réglage de celui-ci ;
- avec un capteur de champ magnétique (3) attribué sans contact à l'aimant (2), à écart de l'aimant, avec utilisation du dit effet magnétorésistif (GMR) ;
- avec un champ d'affichage à cristaux liquides (4) disposé dans un plan entre le commutateur, en particulier entre le bouton de commande (1) resp. l'aimant (2) d'une part, et le capteur de champ magnétique (3) d'autre part.

3. Dispositif d'actionnement et d'affichage selon la revendication précédente
- avec un axe de rotation fictif (1.1) entre le bouton de commande tournant (1) d'une part et le capteur de champ magnétique (3) d'autre part ;
- avec des affichages du bouton de commande (p. ex. 4.21 - 4.25) répartis autour de l'axe de rotation fictif (1.1), disposés en particulier de manière concentrique autour de l'axe de rotation fictif.

4. Dispositif d'actionnement et d'affichage selon au moins l'une quelconque des revendications précédentes
- avec un champ d'affichage à cristaux liquides (4) commandable au sens d'un affichage multifonctions avec affichages de fonctions alternants (4.1 resp. 4.2) et/ou avec affichages de déroulement de fonctions (4.3).

5. Dispositif d'actionnement et d'affichage selon la revendication précédente
- avec différents affichages de fonctions réglables (4.1 resp. 4.2) resp. différents affichages de déroulement de fonctions réglables (4.3) au moyen d'un dispositif de commande, en particulier par l'actionnement multiple différent d'au moins une touche (8 ; 9).

6. Dispositif d'actionnement et d'affichage selon au moins l'une quelconque des revendications précédentes
- avec un panneau frontal (5) transparent disposé devant le champ d'affichage à cristaux liquides (4).

7. Dispositif d'actionnement et d'affichage selon au moins l'une quelconque des revendications précédentes
- avec un bouton de commande (1) réglable disposé du côté avant du panneau frontal (5) resp. du champ d'affichage à cristaux liquides (4) ;
- avec un capteur de champ magnétique disposé au dos du panneau frontal (5) resp. du champ d'affichage à cristaux liquides (4), de préférence comme capteur de champ magnétique en liaison avec une plaquette à circuit imprimé.

8. Dispositif d'actionnement et d'affichage selon au moins l'une quelconque des revendications précédentes
- avec un bouton de commande (1) mobile pouvant être mis à proximité d'intervention du capteur de champ magnétique (3) resp. pouvant être retiré de celui-ci.

9. Dispositif d'actionnement et d'affichage selon la revendication précédente
- avec une aide d'orientation resp. de réglage du bouton de commande (1) déplaçable sur le champ d'affichage à cristaux liquides (4) resp. sur le panneau frontal (5).

10. Dispositif d'actionnement et d'affichage selon au moins l'une quelconque des revendications précédentes
- avec une aide de positionnement (5.1 ; 5.2) du commutateur sur le côté avant du panneau frontal (5).

11. Dispositif d'actionnement et d'affichage selon la revendication précédente 9
- avec une broche rotative à emboîter (5.1) comme aide de positionnement.

12. Dispositif d'actionnement et d'affichage selon la revendication précédente 9
- avec un entonnoir de guidage (5.2) comme aide de positionnement.
